# EUROPEAN PATENT APPLICATION

(11) **EP 2 065 936 A2**
(43) Date of publication of application: **03.06.2009**
(21) Application number: 08020036.3
(22) Date of filing: 17.11.2008
(51) Int. Cl.: H01L 25/065

(54) **System-in-package**

(30) Priority: 29.11.2007 JP 2007308898
(71) Applicant: NEC Electronics Corporation, Kawasaki, Kanagawa 211-8668 (JP)
(72) Inventor: Suzuki, Katsunobu, Kawasaki Kanagawa 211-8668 (JP); Ikeuchi, Takao, Kawasaki Kanagawa 211-8668 (JP); Tajima, Fumihiko, Kawasaki Kanagawa 211-8668 (JP); Maehara, Kazuaki, Kawasaki Kanagawa 211-8668 (JP); Kawamura, Hajime, Kawasaki Kanagawa 211-8668 (JP); Wakasugi, Makoto, Kawasaki Kanagawa 211-8668 (JP)
(74) Representative: Glawe, Delfs, Moll

(57) **Abstract**

A System-in-Package includes a first chip to be mounted in common for a plurality of product types, a second chip having different specifications for each product type, and a wiring substrate being common to a plurality of product types, on which the first chip and the second chip are to be mounted. A setting signal is supplied from the second chip to the first chip.

## Description

### BACKGROUND

### 1. Field of the Invention

The present invention relates to a System-in-Package and, particularly, to a System-in-Package in which a chip that includes a central processing unit (CPU) and is used in common for a plurality of types of products and a custom chip that implements different circuitry and specifications with a wiring layer being different for each type of product are combined in one package.

### 2. Description of Related Art

Recently, the largest possible number of functional blocks constituting a system are integrated in one semiconductor device in order to implement many functions with a small mounting area. One of such semiconductor devices is a System-On-α-Chip (SoC) in which a plurality of functional blocks are formed on a single semiconductor chip. The SoC implements all functional blocks in one semiconductor process.
However, some kind of functional blocks cannot be implemented by the process or it is not efficient to manufacture a semiconductor chip by the process. For example, if a chip size is too large due to the need for mounting high-capacity memory or the like, the percentage of non-defective items decreases significantly, thus failing to manufacture a semiconductor chip. Further, when implementing both of the function which is used in common for a plurality of product types (which is referred to hereinafter as a common function) and the function whose specifications are different for each product type (which is referred to hereinafter as an individual function) in the SoC, it is necessary to design and manufacture the semiconductor chip for each product type in any case. Thus, the SoC takes a long development period and requires a high development cost.

As a semiconductor device architecture that addresses such issues, a System-in-Package (SiP) is developed. The SiP is configured by forming a system with a plurality of semiconductor chips and integrating the semiconductor chips into one package. With the use of the SiP, it is possible to implement the common function with one semiconductor chip (which is referred to hereinafter as a common chip) by means of a most-advanced fine process and implement the individual function for each product type with a semiconductor chip (hereinafter as an individual chip) different from the common chip by means of a previous generation process, for example. It is further possible to design and manufacture the common chip in advance and then design and manufacture the individual chip later in accordance with the specifications of a user, thus enabling shortening of a development period and reduction a development cost. Further, because the SiP allows connection of different chips, a limitation on chip size is significantly less than the SoC. Furthermore, because the SiP allows formation of a system with an arbitrary chip, constraints in terms of a production cost and other costs are particularly reduced. A module on which a plurality of semiconductor chips are mounted, regardless of their functions, is sometimes called a Multi-Chip-Module (MCM).

Examples of the SiP are disclosed in Japanese Unexamined Patent Application Publication Nos. 10-111864 (related art 1) and 2000-223657 (related art 2). The semiconductor device described in the related arts 1 and 2 are the SiP or the MCM, in which a sub-chip of a smaller size is placed on top of a main chip of the largest size. In this semiconductor device, the sub-chip includes connection terminals of a Ball Grid Array (BGA) type on its back side. On the other hand, the main chip includes pads on its front side at the positions corresponding to the connection terminals of the sub-chip. The sub-chip is mounted on top of the main chip to thereby integrate them into one package. The semiconductor device that packages the semiconductor chips in such a laminated structure is called a Chip-on-Chip (CoC).

Another example of the SiP is disclosed in Japanese Domestic Re-publication of PCT Publication No. WO2002/57921 (related art 3). The semiconductor device of the related art 3 is the MCM for detecting a defect at an early stage during the development of the SoC. In the MCM, a plurality of semiconductor chips that implement the functions to be packaged in the SoC are mounted on a build-up substrate. Particularly, a Field Programmable Gate Array (FPGA) that enables a programmable change in a logic circuit is mounted on the build-up substrate. It is thereby possible to implement the individual function for each product type at an early stage and verify whether there is a defect. Further, in order to achieve high speed communication and highly accurate reproduction of functions in the SoC, it is necessary to integrate the semiconductor chips on the build-up substrate (which is referred to hereinafter as a module substrate) with high density.
To realize the high-density integration, semiconductor chips in a Chip Size Package (CSP) having terminals of the BGA type, for example, are integrated with face-down positioning in the related art 3, thereby reducing a space between the adjacent semiconductor chips.

### SUMMARY

The present inventors, however, have found a problem about the related arts. Specifically, in the case of performing the operation setting of the chip mounted on the package with use of an externally input control signal or the like, a terminal for inputting the control signal needs to be placed on the package in the above-described related arts 1 to 3. Therefore, if the number of signals contained in the control signal increases, the number of terminals on the package increases accordingly, which causes a problem that a necessary terminal cannot be placed on the package.

A first exemplary aspect of an embodiment of the present invention is a System-in-Package including a first chip to be mounted in common for a plurality of product types, a second chip having different specifications for each product type, and a wiring substrate being common to a plurality of product types where the first chip and the second chip are to be mounted, in which a setting signal is supplied from the second chip to the first chip.

In the System-in-Package according to the exemplary embodiment of the present invention, the setting signal for the first chip is supplied from the second chip. This eliminates the need for placing an input terminal of the setting signal for the first chip on the wiring substrate. It is thereby possible to reduce the number of terminals placed on the wiring substrate in the System-in-Package according to the exemplary embodiment of the present invention.

The System-in-Package according to the exemplary embodiment of the present invention enables reduction of the number of terminals placed on the wiring substrate.

### BRIEF DESCRIPTION OF THE DRAWINGS

The above and other exemplary aspects, advantages and features will be more apparent from the following description of certain exemplary embodiments taken in conjunction with the accompanying drawings, in which:
Fig. 1 is a top view of a SiP according to a first exemplary embodiment of the present invention;
Fig. 2 is a back view of the SiP according to the first exemplary embodiment of the present invention;
Fig. 3 is a sectional view of the SiP according to the first exemplary embodiment of the present invention;
Fig. 4 is a block diagram of an ASSP and a G/A in the SiP according to the first exemplary embodiment of the present invention;
Fig. 5 is a top view of a SiP as a comparative example to the SiP according to the first exemplary embodiment of the present invention;
Fig. 6 is a block diagram of an ASSP and a G/A in a SiP according to a second exemplary embodiment of the present invention;
Fig. 7 is a block diagram showing an alternative example of the ASSP and the G/A in the SiP according to the second exemplary embodiment of the present invention;
Fig. 8 is a top view of a SiP according to a third exemplary embodiment of the present invention;
Fig. 9 is a top view of the SiP, from which an ASSP is removed, according to the third exemplary embodiment;
Fig. 10 is a sectional view of the SiP according to the third exemplary embodiment of the present invention;
Fig. 11 is top view of a SiP according to a fourth exemplary embodiment of the present invention; and
Fig. 12 is a sectional view of the SiP according to the fourth exemplary embodiment of the present invention.

### DETAILED DESCRIPTION OF THE EXEMPLARY EMBODIMENTS

### [First exemplary embodiment]

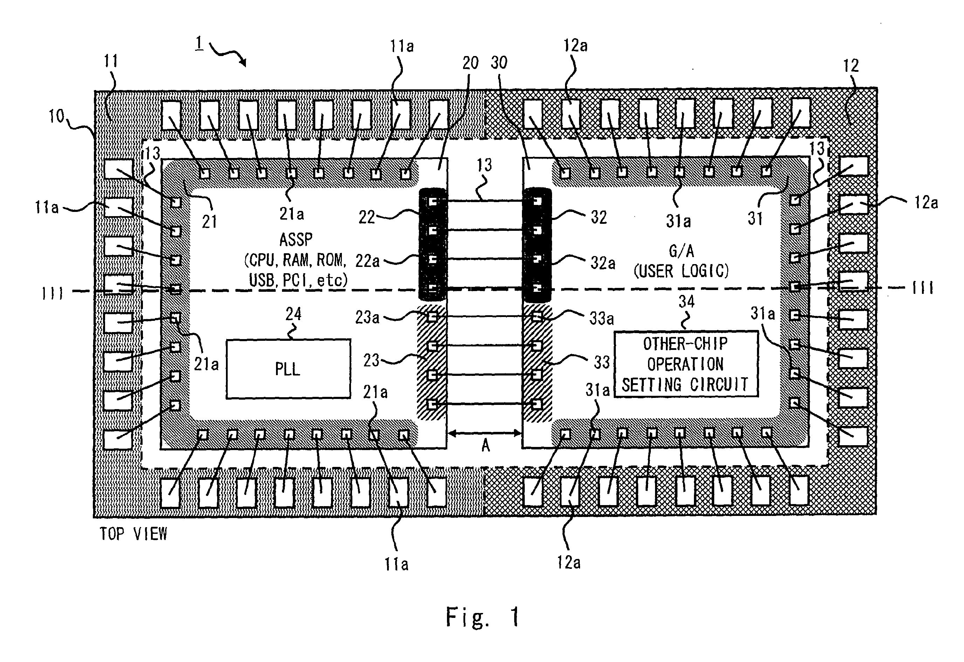

Exemplary embodiments of the present invention are described hereinafter with reference to the drawings. In the following description, although not every one of a plurality of elements such as pads and bonding wires is denoted by a reference numeral for simplification of the drawings, the elements having an identical shape located in the same area as the element denoted by a reference numeral are the same as the denoted element. Fig. 1 is a top view of a semiconductor device according to an exemplary embodiment of the present invention. The semiconductor device of this exemplary embodiment is a System-in-Package (which is referred to hereinafter simply as a SiP) in which a system including a CPU is placed in one package. Referring to Fig. 1, a SiP 1 of this exemplary embodiment includes a wiring substrate 10, a first chip (e.g. Application Specific Standard Product (ASSP)) 20, and a second chip (e.g. Gate Array (G/A)) 30, for example.

The wiring substrate 10 includes substrate pads 11a and 12a in its periphery. Further, the ASSP 20 and the G/A 30 are placed adjacent to each other in the area surrounded by the substrate pads 11a and 12a. A plurality of substrate pads 11a are placed in a common pad placement area 11 that surrounds the three sides of the area where the ASSP 20 is placed in the periphery of the wiring substrate 10. A plurality of substrate pads 12a are placed in an individual pad placement area 12 that surrounds the three sides of the area where the G/A 30 is placed in the periphery of the wiring substrate 10. The substrate pads 12a are pads to be connected to chip pads, which are described later. The substrate pads 11a and 12a are electrically connected to package terminals that are formed on the backside of the wiring substrate 10. The package terminals are described in detail later.

The ASSP 20 is a semiconductor device on which the common functions used in common for a plurality of product types are mounted, and it is used in common for a plurality of SiPs. The ASSP 20 includes a CPU, ROM and RAM and further includes a circuit that implements the peripheral functions of the CPU, such as a PCI controller, a USB controller and a DAC, for example.
The CPU, ROM, RAM and so on that are included in the ASSP 20 are an intellectual property (IP) core stored in the same chip. Further, the ASSP 20 includes an oscillator (e.g. a phase-locked loop (PLL)) 24 that generates an operation clock of an internal circuit such as the CPU. Furthermore, the ASSP 20 includes chip pads 21a, first in-package connection terminals 22a, and operation setting terminals 23a in its periphery.

The chip pads 21a are formed in an external interface placement area 21 that is defined along the three sides not facing the G/A 30. The first in-package connection terminals 22a are formed in an internal interface placement area 22 that is defined along a first side facing the G/A 30. The operation setting terminals 23a are formed in an operation setting terminal placement area 23 that is defined along the first side facing the G/A 30. The chip pads 21a are connected to the substrate pads 11a by bonding wires 13 to establish an electrical connection with the outside of the wiring substrate 10. The first in-package connection terminals 22a and the operation setting terminals 23a are connected to the G/A 30 by the bonding wires 13.

The G/A 30 is a circuit that implements the individual function which is different for each product type, and it has a different circuit configuration and chip size for each user to which the SiP 1 is to be supplied. The G/A 30 includes an other-chip operation setting circuit 34 that generates a setting signal for the ASSP 20. In this exemplary embodiment, a gate array that implements a desired function by the design of a wiring layer only is used as the second chip. However, the second chip may be any semiconductor device that is designed individually for each product type. Particularly, if the second chip is a semifinished chip with a completed transistor, whose wiring portion can be formed separately, it is possible to shorten a time for designing and manufacturing the second chip. For the second chip, an embedded array that includes a plurality of completed logic gates and a small number of completed functional blocks, the combination of which is to be changed by a wiring layer, or a standard cell that includes functional blocks with completed in-block wiring, which can implement a desired function by changing the wiring between the functional blocks, may be used. A specific configuration for performing the operation setting of the ASSP 20 by means of the other-chip operation setting circuit 34 is described later.

The G/A 30 includes chip pads 31a, second in-package connection terminals 32a and operation setting terminals 33a in its periphery. The chip pads 31a are formed in an external interface placement area 31 that is defined along the three sides not facing the ASSP 20. The second in-package connection terminals 32a are formed in an internal interface placement area 32 that is defined along a second side facing the ASSP 20. The operation setting terminals 33a are formed in an operation setting terminal placement area 33 that is defined along the second side facing the G/A 30. The chip pads 31a are connected to the substrate pads 12a by the bonding wires 13 to establish an electrical connection with the outside of the wiring substrate 10. The second in-package connection terminals 32a are connected to the first in-package connection terminals 22a of the ASSP 20 by the bonding wires 13. The operation setting terminals 33a are placed in the positions opposite to the positions in which the operation setting terminals 23a of the ASSP 20 are to be placed. Placing the operation setting terminals 33a and the operation setting terminals 23a in such a positional relationship facilitates the bonding process.

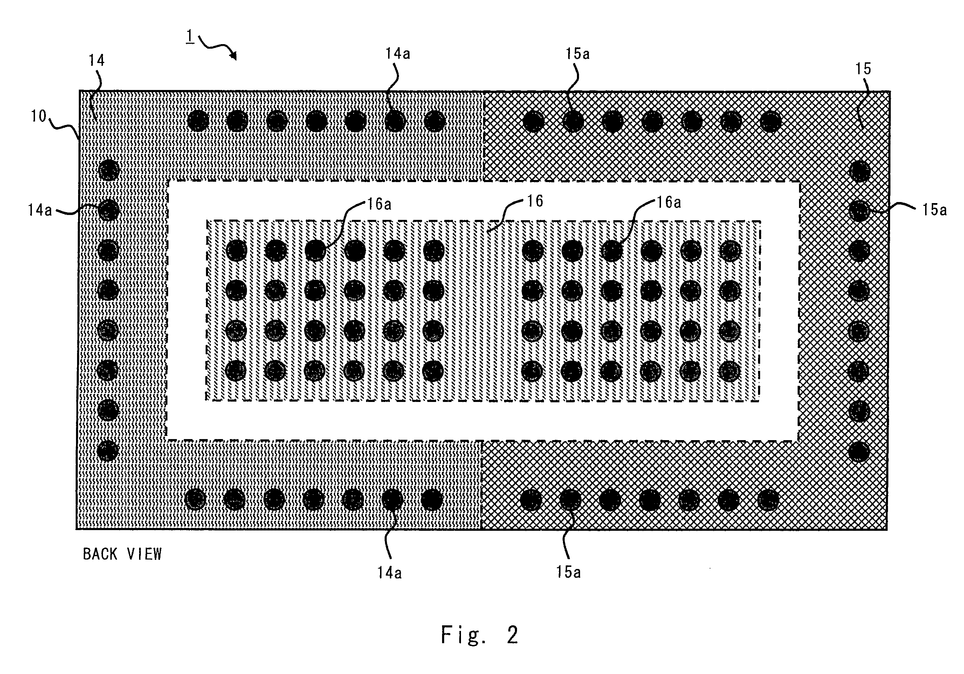

The package terminals that are placed on the backside of the wiring substrate 10 are described hereinafter. Fig. 2 is a back view of the wiring substrate 10. Referring to Fig. 2, a common specification terminal placement area 14, an individual specification terminal placement area 15, and a free terminal placement area 16 are defined on the backside of the wiring substrate 10.

First package terminals 14a are placed in the common specification terminal placement area 14. The functions and the arrangement of the first package terminals 14a are the same among different product types of SiPs. The first package terminals 14a are connected to the substrate pads 11a placed on the front side by a line that is formed inside the wiring substrate. Thus, the functions of the first package terminals 14a are determined by the functions of the ASSP 20 to be mounted and the terminal arrangement of the chip pads 21a.

Second package terminals 15a are placed in the individual specification terminal placement area 15. The functions and the arrangement of the second package terminals 15a differ according to the product type of SiP. The second package terminals 15a are connected to the substrate pads 12a placed on the front side by a line that is formed inside the wiring substrate. Thus, the functions of the second package terminals 15a are determined by the functions of the G/A 30 to be mounted and the terminal arrangement of the chip pads 31a.

Third package terminals 16a are placed in the free terminal placement area 16. The third package terminals 16a may be used as heat dissipation terminals of the ASSP 20 and the G/A 30, for example. In such a case, the third package terminals 16a are connected to the backside of the ASSP 20 and the G/A 30 respectively through lines that are formed inside the wiring substrate. The third package terminals 16a are further connected to a ground plane or a heat dissipation plate, so that the third package terminals 16a function as dissipation terminals. The third package terminals 16a may be also used as power supply terminals.

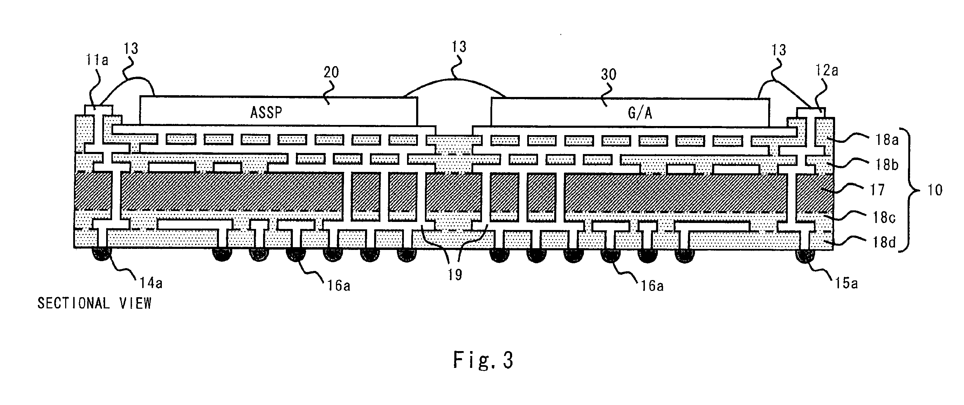

The sectional structure of the SiP 1 is described hereinafter. Fig. 3 shows a sectional view of the SiP 1 along line III-III in Fig. 1. Referring to Fig. 3, the wiring substrate 10 includes a support substrate 17. On both sides of the support substrate 17, a plurality of wiring layers 18a to 18d are formed. On the front side of the wiring substrate 10, the substrate pads 11a and 12a are placed in the area corresponding to the periphery of the wiring substrate 10. Further, in this exemplary embodiment, the ASSP 20 and the G/A 30 are placed in prescribed positions on the wiring substrate 10, and a ground plane is formed in contact with the underside of the ASSP 20 and the underside of the G/A 30. In-layer lines are placed in desired areas of the wiring layers 18a to 18d of the wiring substrate 10.
The in-layer lines are connected through a via hole (e.g. a blind via hole or a through hole). The via hole serves as a part of the line. The in-layer line and the via hole form an in-substrate line 19. The in-substrate line 19 connects the substrate pads 11a and 12a and the ground plane with the package terminals placed on the backside of the wiring substrate 10 as appropriate. Although not shown, the wiring substrate 10, the ASSP 20, the G/A 30 and the bonding wires 13 are covered with a molding material such as a resin.

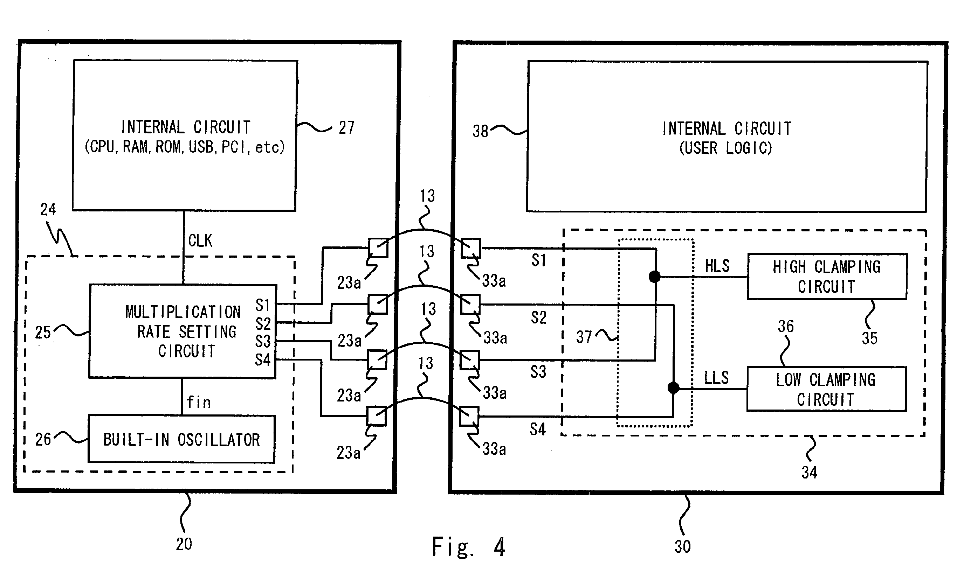

The configuration for performing the operation setting of the ASSP 20 in this exemplary embodiment is described hereinafter. Fig. 4 shows a block diagram of the ASSP 20 and the G/A 30. In Fig. 4, the block related to the operation setting of the ASSP 20 is mainly shown for simplification.

Referring to Fig. 4, the ASSP 20 includes the operation setting terminals 23a, the PLL 24 and an internal circuit 27. The internal circuit 27 includes a circuit for implementing the functions provided by the ASSP 20. The internal circuit 27 operates according to an operation clock CLK that is output from the PLL 24. The PLL 24 includes a built-in oscillator 26 and a multiplication rate setting circuit 25. The built-in oscillator 26 generates a reference clock fin that serves as a reference to the operation clock CLK that is output from the PLL 24. The multiplication rate setting circuit 25 sets a multiplication rate based on setting signals S1 to S4 that are input through the operation setting terminals 23a. Then, the multiplication rate setting circuit 25 outputs the operation clock CLK by multiplying the frequency of the reference clock fin. Although the built-in oscillator 26 is used in this exemplary embodiment, the oscillator may be placed externally. In such a case, it is possible to share the clock generated by the oscillator with another device.

The G/A 30 includes the operation setting terminals 33a, the other-chip operation setting circuit 34 and an internal circuit 38. The internal circuit 38 is a circuit whose specifications are different for each product type, which is designed according to a desire of a user. The other-chip operation setting circuit 34 includes a high clamping circuit 35, a low clamping circuit 36 and a distribution unit 37. The high clamping circuit 35 outputs a first setting voltage (which is referred to hereinafter as a high level setting signal) HLS. The high level setting signal HLS may have the same voltage value as an operation power supply voltage of the ASSP 20, for example. The low clamping circuit 36 outputs a second setting voltage (which is referred to hereinafter as a low level setting signal) LLS. The low level setting signal LLS may have the same voltage value as a ground voltage of the ASSP 20, for example. The distribution unit 37 sets through which of the operation setting terminals 33a the high level setting signal HLS and the low level setting signal LLS are to be output. Specifically, the distribution unit 37 sets which of the high level setting signal HLS and the low level setting signal LLS is to be distributed to the operation setting terminal 33a. In the example shown in Fig. 4, four operation setting terminals 33a are placed, and signals that are supplied from the distribution unit 37 to the operation setting terminals 33a are the setting signals S1 to S4. In the example of Fig. 4, the high level setting signal HLS is distributed to the setting signals S1 and S3, and the low level setting signal LLS is distributed to the setting signals S2 and S4.

In this exemplary embodiment, the operation setting terminals 23a of the ASSP 20 and the operation setting terminals 33a of the G/A 30 are connected by the bonding wires 13. Therefore, the setting signals that are generated in the other-chip operation setting circuit 34 of the G/A 30 are supplied to the ASSP 20 through the bonding wires 13. Then, the ASSP 20 operates the internal circuit 27 according to the operation clock CLK having the frequency that is set by the PLL 24 based on the setting signal supplied from the G/A 30.

As described in the foregoing, in the SiP 1 according to the exemplary embodiment, the setting signal generated in the G/A 30 is supplied to the ASSP 20, and the operation setting of the ASSP 20 is performed based on the supplied setting signal. The setting signal for the ASSP 20 is thereby supplied to the ASSP 20 without use of the terminal placed on the wiring substrate. It is thus possible to reduce the number of terminals placed on the wiring substrate in the SiP 1 according to the exemplary embodiment.

The SiP 1 according to the first exemplary embodiment of the present invention is particularly effective when using a commercially available ASSP, a CPU that can operate on a standalone basis or the like (which are hereinafter referred to simply as a commercially available ASSP) as the first chip. The use of the commercially available ASSP as the first chip eliminates the need for a design work for the first chip, thereby significantly reducing a development period and a development cost. The commercially available ASSP, however, has specifications that allow input of external setting signals in order to change the operation setting of the chip, such as setting an operation frequency by the setting of the PLL or the like. Thus, in the case of using such a commercially available ASSP as the first chip of the SiP 1, it is necessary to input the setting signal for the commercially available ASSP externally. However, a setting signal input terminal for the commercially available ASSP cannot be placed on the wiring substrate in some cases due to the limitation to the number of terminals placed on the wiring substrate of the SiP 1 or the specifications of the wiring substrate. In view of this, the SiP 1 according to the exemplary embodiment enables the setting signal for the commercially available ASSP to be supplied from the G/A 30, which is used as the second chip, without placing a package terminal on the wiring substrate. Thus, the SiP 1 according to the exemplary embodiment can supply the setting signal to the commercially available ASSP regardless of the specifications of the wiring substrate. Accordingly, the SiP 1 according to the exemplary embodiment allows the wiring substrate to have the specifications that are common for a plurality of product types, regardless of the specifications of the commercially available ASSP which is mounted as the first chip. Therefore, in the SiP 1 according to the exemplary embodiment, it is possible to reduce the development period and the cost by mounting the commercially available ASSP and further to reduce the development period and the cost for the wiring substrate, thereby enabling provision of a low-cost, high-performance SiP 1 with a short development period.

Approaches to reduce the number of terminals placed on the wiring substrate in a different way from the SiP 1 according to the exemplary embodiment are illustrated hereinafter as comparative examples 1 and 2. Further, the advantages specific to the SiP 1 according to the exemplary embodiment are described by contrast with the comparative examples.

One approach to reduce the number of terminals, which is the comparative example 1, is to use a storage portion that stores operation setting information for the ASSP 20 within the ASSP 20. The use of the comparative example 1 eliminates the need for externally inputting a setting signal, thereby reducing the number of terminals on the wiring substrate. However, information on a setting value related to the fundamental operation of the ASSP 20 such as the operation setting of the PLL 24 cannot be read from the storage portion unless the PLL 24 operates. Further, if the ASSP 20 is operated according to the operation clock CLK that is output from the PLL 24 whose setting is unfixed, the ASSP 20 fails to function properly. Furthermore, if the ASSP 20 is operated based on the setting where a fixed value is always output from the storage portion, it is impossible to change the operation setting for each product type.

In contrast to this, the SiP 1 according to the exemplary embodiment prevents malfunction of the ASSP 20 by operating the G/A 30 firstly and then operating the ASSP 20 after determining the setting signal to be supplied to the ASSP 20. Further, because the G/A 30 is designed for each product type, the setting signal for the ASSP 20 can be set for each product type at the time of designing the G/A 30. The SiP 1 according to the exemplary embodiment thereby facilitates a change in the setting signal for each product type.

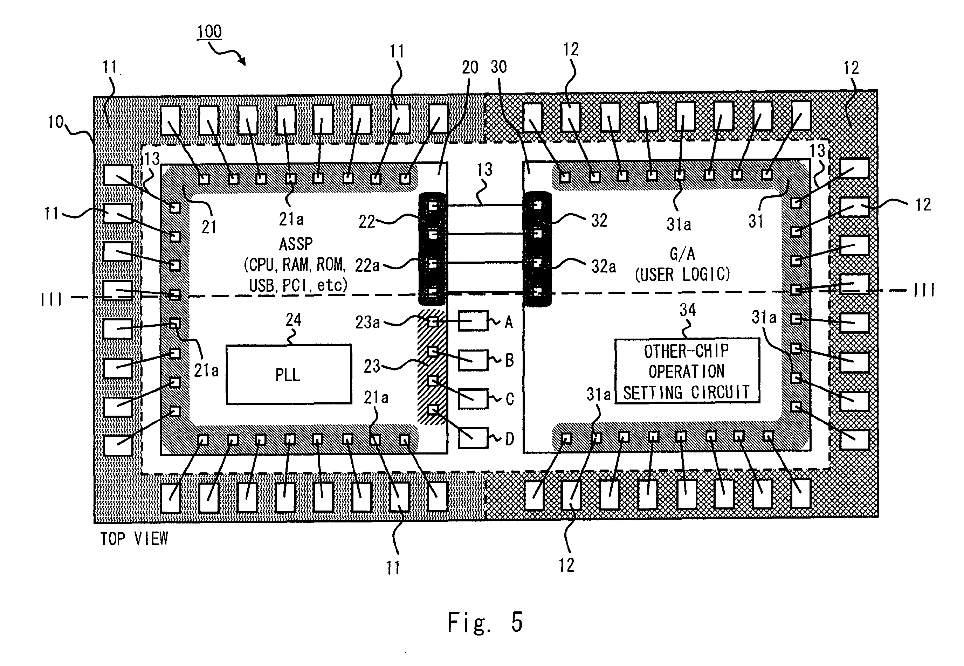

Fig. 5 shows a schematic view of a SiP 100 according to another approach to reduce the number of terminals, which is the comparative example 2.
Referring to Fig. 5, the SiP 100 according to the comparative example 2 includes operation setting pads A to D on the wiring substrate. The operation setting terminals 23a of the ASSP 20 are connected to the operation setting pads A to D by the bonding wires 13. In the SiP 100, the setting signal to be supplied to the ASSP 20 is changed by altering a voltage applied to the operation setting pads A to D. A power supply voltage or a ground voltage is supplied to the operation setting pads A to D through an in-substrate line in the wiring substrate. By distributing the power supply voltage or the ground voltage to be supplied to the ASSP 20 or the G/A 30 to the operation setting pads A to D through the in-substrate line, it is possible to change the setting signal without increasing the number of package terminals on the wiring substrate. However, it is necessary to redesign the wiring substrate each time the setting signal is changed in the comparative example 2, causing an increase a development period and a manufacturing period. This also leads to an increase in a development cost and a manufacturing cost.

In contrast to this, in the SiP 1 according to the exemplary embodiment, it is possible to change the setting signal at the time of designing the G/A 30, which is designed for each product type. Thus, a problem such as an increase in development period, which occurs in the comparative example 2, does not occur in the exemplary embodiment. The SiP 1 according to the exemplary embodiment thereby enables shortening of a development period and a manufacturing period, and reduction of a development cost and a manufacturing cost.

### [Second exemplary embodiment]

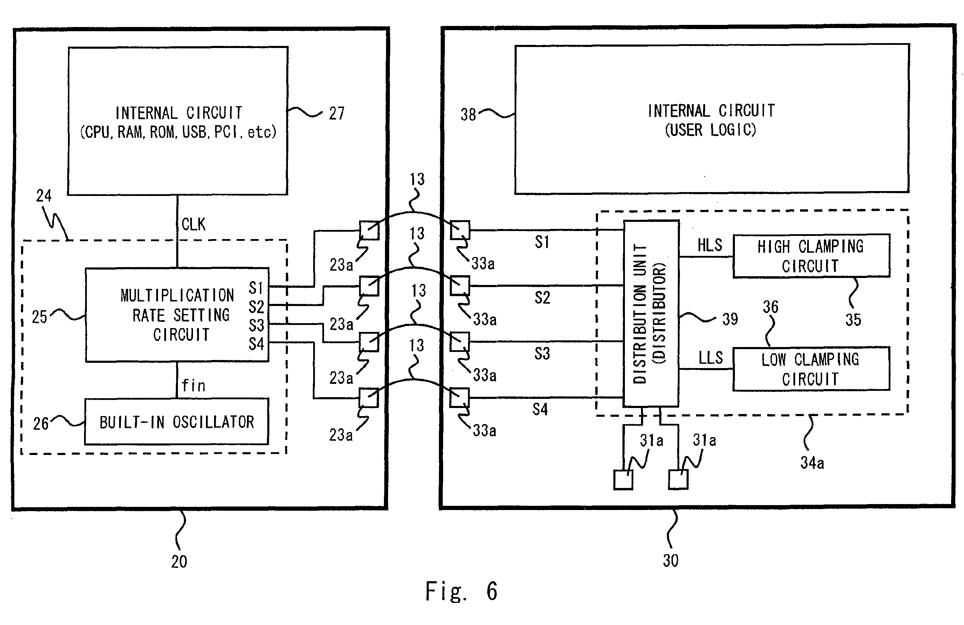

An alternative example of the other-chip operation setting circuit 34 is described hereinafter as a second exemplary embodiment of the present invention. An other-chip operation setting circuit 34a according to the second exemplary embodiment includes a distributor 39 as a circuit corresponding to the distribution unit 37. Referring to Fig. 6,The distributor 39 switches which of the high level setting signal HLS and the low level setting signal LLS is to be distributed to the operation setting terminal 33a based on a control signal that is input through the chip pad 31a. The output of the distributor 39 is connected to the operation setting terminals 33a. The signals output from the distributor 39 serve as the setting signals S1 to S4.

The use of the distributor 39 enables changing the setting signals S1 to S4 to be supplied from the G/A 30 to the ASSP 20 by an external control. For example, it is possible to switch between the setting to supply the high level setting signal HLS to all of the setting signals S1 to S4 and the setting to supply the high level setting signal HLS to the setting signals S1 and S2 and supply the low level setting signal LLS to the setting signals S3 and S4 based on the externally input control signal. Thus, the alternative example described in the second exemplary embodiment achieves a higher flexibility in the operation setting than the example described in the first exemplary embodiment.

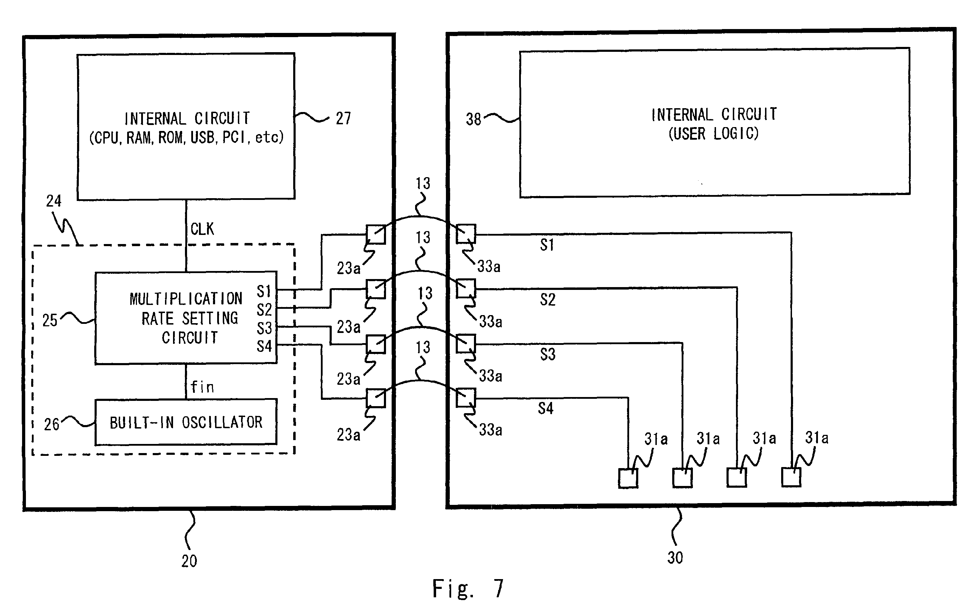

If there is a non-used terminal to which no function is set among the package terminals, the setting signals may be input externally without using the other-chip operation setting circuit 34 in Fig. 4 or the other-chip operation setting circuit 34a in Fig. 6. Fig. 7 shows a block diagram of the SiP 1 in the case where there is the sufficient number of package terminals. In the example shown in Fig. 7, the chip pads 31a and the operation setting terminals 33a are connected by lines formed on the G/A 30. Such a configuration allows reduction of an area for forming the other-chip operation setting circuit 34 or the other-chip operation setting circuit 34a, thereby making the chip area of the G/A 30 smaller.

### [Third exemplary embodiment]

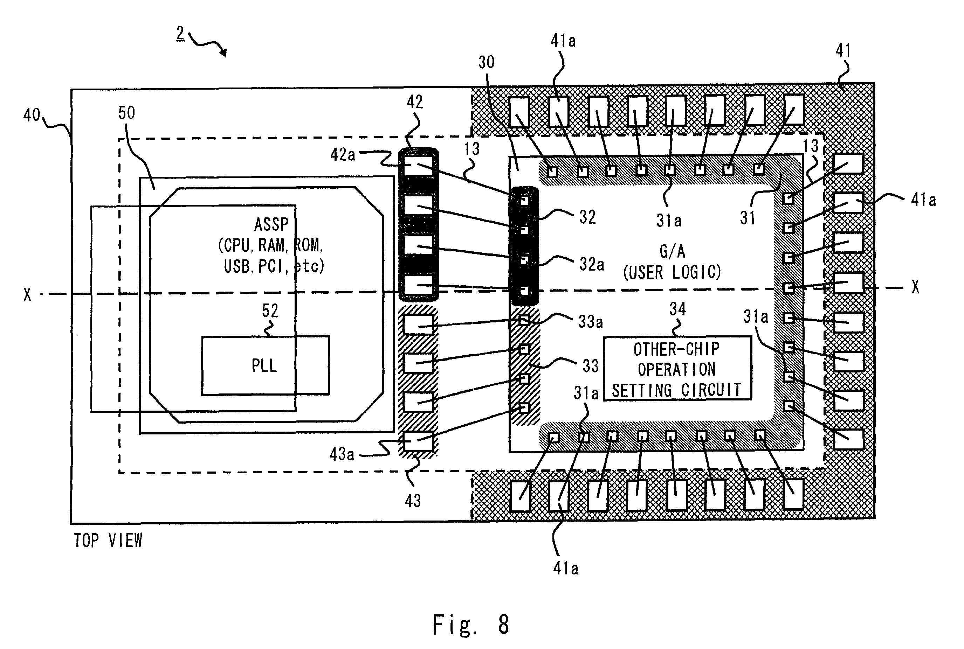

A SiP 2 according to a third exemplary embodiment of the present invention is such that the ASSP used in common for different SiPs 2 is a semiconductor device of the BGA type. Fig. 8 shows a plan view of the SiP 2. Referring to Fig. 8, in the SiP 2, an ASSP 50 is mounted on a wiring substrate 40 as a semiconductor device corresponding to the ASSP 20 in the first exemplary embodiment. A PLL 52 is placed on the ASSP 50. The PLL 52 controls the frequency of the operation clock CLK based on the setting signal that is input through a prescribed terminal placed on the ASSP 50. Further, first in-package connection terminals 42a and operation setting terminals 43a are placed on the wiring substrate 40 in the area of the ASSP 50 along the side facing the G/A 30. The first in-package connection terminals 42a are formed in an internal interface placement area 42 that is defined along a first side facing the G/A 30. The operation setting terminals 43a are formed in an operation setting terminal placement area 43 that is defined along the first side facing the G/A 30. The SiP 2 also includes an individual pad placement area 41 and substrate pads 41a, which correspond to the individual pad placement area 12 and the substrate pads 12a.

The first in-package connection terminals 42a and the operation setting terminals 43a are connected to prescribed terminals of the ASSP 50 by an in-substrate line of the wiring layer that is formed in the wiring substrate. Further, the first in-package connection terminals 42a are connected to the second in-package connection terminals 32a of the G/A 30 by the bonding wires 13. Likewise, the operation setting terminals 43a are connected to the operation setting terminals 33a of the G/A 30 by the bonding wires 13.

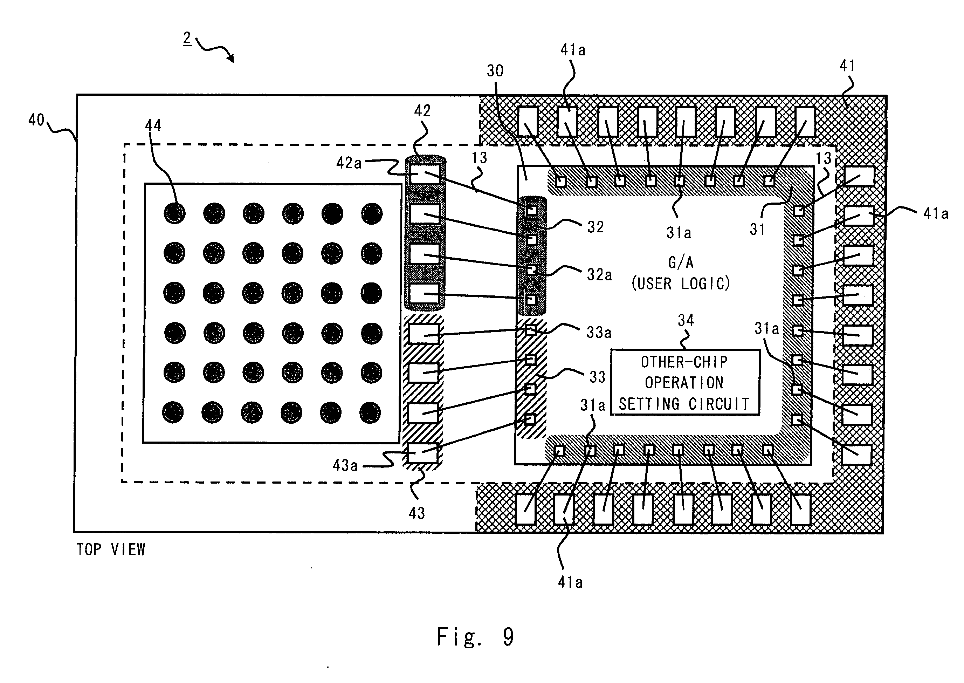

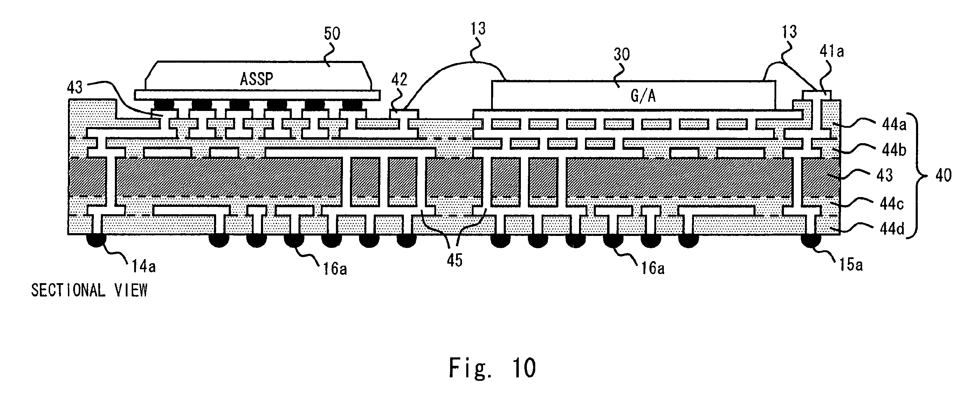

Fig. 9 shows a plan view in the case where the ASSP 50 is removed from the wiring substrate 40 of the SiP 2. Referring to Fig. 9, in the area of the wiring substrate 40 where the ASSP 50 is to be placed, connection terminals 44 to which the terminals of the ASSP 50 are to be connected are formed according to the terminal arrangement of the ASSP 50. Fig. 10 shows a sectional view of the SiP 2 along line X-X in Fig. 8. Referring to Fig. 10, the connection terminals 44 are connected to the operation setting terminals 43a or the first in-package connection terminals 42a by an in-substrate line 45 that are formed in wiring layers 44a to 44d.

As described in the foregoing, in the SiP 2 also, by placing the operation setting terminals 43a on the wiring substrate 40, the operation setting terminals 43a can be connected to the operation setting terminals 33a by the bonding wires 13. It is therefore possible to supply the setting signals for the ASSP 50 from the G/A 30 as in the first exemplary embodiment, regardless of the way of mounting the ASSP 50. Thus, it is not necessary to supply the setting signals for the ASSP 50 externally in the third exemplary embodiment as well, thereby enabling reduction of the number of terminals just like the first exemplary embodiment.

### [Fourth exemplary embodiment]

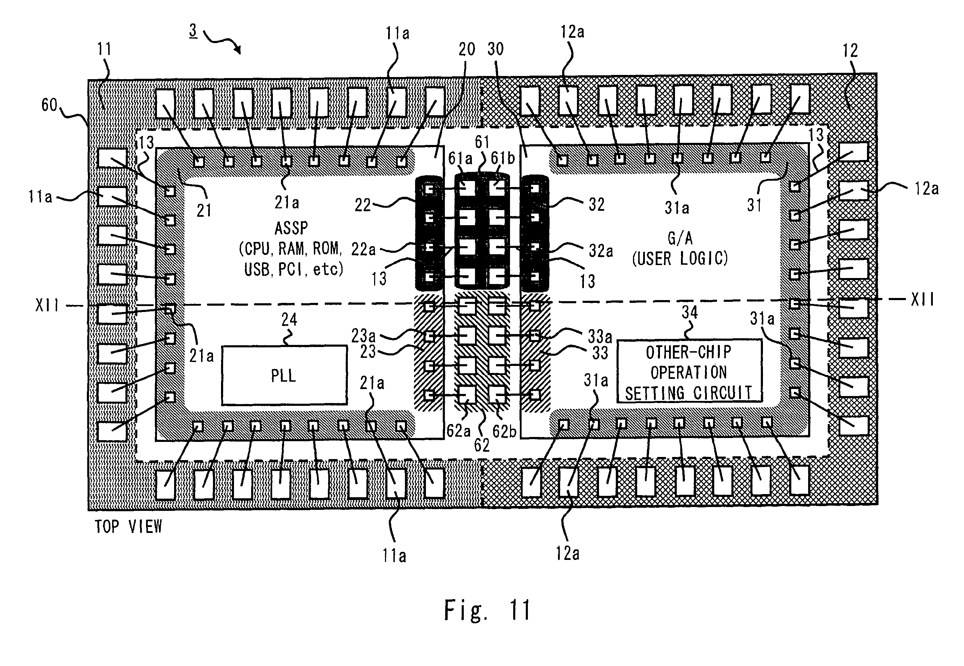

The case where the ASSP 20 and the G/A 30 are connected through pads placed on the wiring substrate, rather than connected directly by the bonding wires 13, is described hereinafter as a fourth exemplary embodiment of the present invention. Fig. 11 shows a top view of a SiP 3 according to the fourth exemplary embodiment. Referring to Fig. 11, in the SiP 3, the ASSP 20 and the G/A 30 are mounted on a wiring substrate 60. The wiring substrate 60 is such that inter-chip connection pads 61a, 61b, 62a and 62b are added to the wiring substrate 10. The elements of the wiring substrate 60 that are identical to those of the wiring substrate 10 are denoted by the same reference numerals as in the wiring substrate 10 and not repeatedly described below.

The inter-chip connection pads 61a and 61b are formed in a first inter-chip connection pad placement area 61. The first inter-chip connection pad placement area 61 is formed in the area between the ASSP 20 and the G/A 30. Specifically, the first inter-chip connection pad placement area 61 is formed in the area between the internal interface placement area 22 of the ASSP 20 and the internal interface placement area 32 of the G/A 30. The inter-chip connection pads 61a are placed closer to the ASSP 20 in the first inter-chip connection pad placement area 61, and the inter-chip connection pads 61b are placed closer to the G/A 30 in the first inter-chip connection pad placement area 61. The inter-chip connection pads 61a and 61b opposite to each other are connected by an in-substrate line, which is described later. Further, the inter-chip connection pads 61a are connected to the first in-package connection terminals 22a of the ASSP 20 by the bonding wires 13, and the inter-chip connection pads 61b are connected to the second in-package connection terminals 32a of the G/A 30 by the bonding wires 13.

The inter-chip connection pads 62a and 62b are formed in a second inter-chip connection pad placement area 62. The second inter-chip connection pad placement area 62 is formed in the area between the ASSP 20 and the G/A 30. Specifically, the second inter-chip connection pad placement area 62 is formed in the area between the operation setting terminal placement area 23 of the ASSP 20 and the operation setting terminal placement area 33 of the G/A 30. The inter-chip connection pads 62a are placed closer to the ASSP 20 in the second inter-chip connection pad placement area 62, and the inter-chip connection pads 62b are placed closer to the G/A 30 in the second inter-chip connection pad placement area 62. The inter-chip connection pads 62a and 62b opposite to each other are connected by an in-substrate line, which is described later. Further, the inter-chip connection pads 62a are connected to the operation setting terminals 23a of the ASSP 20 by the bonding wires 13, and the inter-chip connection pads 62b are connected to the operation setting terminals 33a of the G/A 30 by the bonding wires 13.

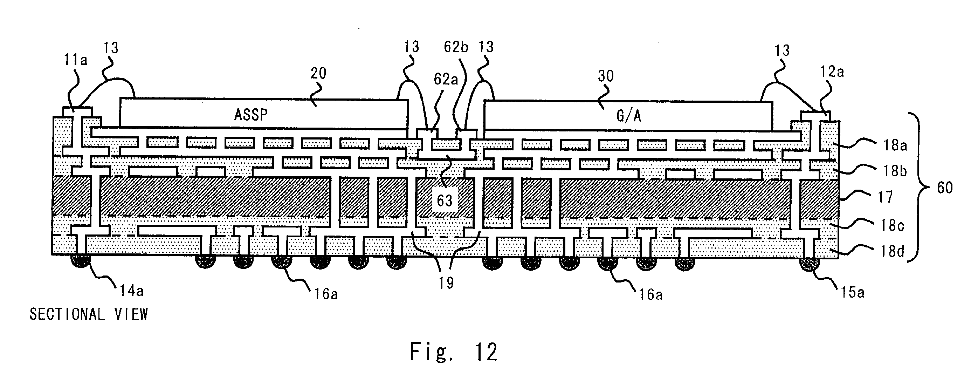

Fig. 12 shows a sectional view of the SiP 3 along line XII-XII in Fig. 11. In Fig. 12, the elements of the wiring substrate 60 that are identical to those of the wiring substrate 10 are denoted by the same reference numerals as in the wiring substrate 10 and not repeatedly described below. Referring to Fig. 12, the inter-chip connection pads 62a and 62b are placed in the area between the ASSP 20 and the G/A 30 on the front side of the wiring substrate 60. Further, an in-substrate line 63 is formed in the wiring substrate 60. The inter-chip connection pads 62a and 62b are connected to each other by the in-substrate line 63.

As described in the foregoing, according to the fourth exemplary embodiment, the ASSP 20 and the G/A 30 are connected through the bonding wires 13, the inter-chip connection pads 61a, 61b, 62a and 62b and the in-substrate line 63. Thus, the fourth exemplary embodiment shows that the present invention is not limited to the configuration where the two chips are connected directly by the bonding wires 13, and they may be connected through the in-substrate line 63, by way of illustration. With such a connection architecture as well, it is possible to make the setting of the ASSP 20 without constraints of the package terminals placed on the wiring substrate, just like the first exemplary embodiment.

The present invention is not limited to the above-descried exemplary embodiments, and various changes and modifications may be made without departing from the scope of the invention. For example, the other-chip operation setting circuit 34 may include a decoder, so that the distributor 39 operates based on the decoding result of the control signal that is input through the chip pad 31a. In such a case, the number of the chip pads 31a and package terminals can be reduced by inputting the control signal as serial data.

The first, second, third and fourth exemplary embodiments can be combined as desirable by one of ordinary skill in the art.

While the invention has been described in terms of several exemplary embodiments, those skilled in the art will recognize that the invention can be practiced with various modifications within the spirit and scope of the appended claims and the invention is not limited to the examples described above.

Further, the scope of the claims is not limited by the exemplary embodiments described above.

Furthermore, it is noted that, Applicant's intent is to encompass equivalents of all claim elements, even if amended later during prosecution.

## Claims

1. A System-in-Package comprising:
a first chip to be mounted in common for a plurality of product types;
a second chip having different specifications for each product type, to supply a setting signal to the first chip; and
a wiring substrate being common to a plurality of product types, to have the first chip and the second chip mounted thereon.

2. The System-in-Package according to Claim 1, wherein the first chip and the second chip respectively include setting signal terminals to input and output the setting signal along sides of the first chip and the second chip facing each other, and the setting signal terminals are placed opposite to each other.

3. The System-in-Package according to Claim 1, wherein the second chip includes an other-chip operation setting circuit to generate the setting signal.

4. The System-in-Package according to Claim 2, wherein the second chip includes an other-chip operation setting circuit to generate the setting signal.

5. The System-in-Package according to Claim 3, wherein the other-chip operation setting circuit includes a first clamping circuit to generate a first setting voltage indicating a first logical level, a second clamping circuit to generate a second setting voltage indicating a second logical level different from the first logical level, and a distribution unit to perform setting as to which of the first setting voltage and the second setting voltage is to be distributed to the setting signal terminals.

6. The System-in-Package according to Claim 4, wherein the other-chip operation setting circuit includes a first clamping circuit to generate a first setting voltage indicating a first logical level, a second clamping circuit to generate a second setting voltage indicating a second logical level different from the first logical level, and a distribution unit to perform setting as to which of the first setting voltage and the second setting voltage is to be distributed to the setting signal terminals.

7. The System-in-Package according to Claim 5, wherein the distribution unit changes setting of a distribution destination of the first setting voltage and the second setting voltage among the setting signal terminals based on an externally input setting change signal.

8. The System-in-Package according to Claim 6, wherein the distribution unit changes setting of a distribution destination of the first setting voltage and the second setting voltage among the setting signal terminals based on an externally input setting change signal.

9. The System-in-Package according to Claim 1, wherein an externally input setting signal is supplied to the first chip through the second chip.

10. The System-in-Package according to Claim 2, wherein an externally input setting signal is supplied to the first chip through the second chip.

11. The System-in-Package according to Claim 1, wherein the setting signal is output from the second chip and supplied to the first chip through the wiring substrate.

12. The System-in-Package according to Claim 1, wherein the setting signal is a control signal for a phase-locked loop (PLL) mounted on the first chip.
